**Europäisches Patentamt**

**European Patent Office**

**Office européen des brevets**

(19)

(11) Veröffentlichungsnummer : **0 024 001**

**B1**

(12)

# EUROPÄISCHE PATENTSCHRIFT

(45) Veröffentlichungstag der Patentschrift :
22.01.86

(21) Anmeldenummer : 80104437.1

(22) Anmeldetag : 28.07.80

(51) Int. Cl.⁴ : **G 11 C  7/06**, G 11 C 17/00

(54) **Schaltungsanordnung mit MOS-Transistoren zum raschen Bewerten des logischen Zustandes eines Abtastknotens.**

(30) Priorität : 10.08.79 DE 2932605

(43) Veröffentlichungstag der Anmeldung :
18.02.81 Patentblatt 81/07

(45) Bekanntmachung des Hinweises auf die Patenterteilung : 22.01.86 Patentblatt 86/04

(84) Benannte Vertragsstaaten :
FR GB

(56) Entgegenhaltungen :
US-A- 3 932 848
US-A- 3 946 369
US-A- 4 103 189
IEEE JOURNAL OF SOLID-STATE CIRCUITS, Band SC-15, Nr. 3, Juni 1980, Seiten 311-315, New York, USA B. GIEBEL: "An 8K EEPROM using the SIMOS storage cell"

(73) Patentinhaber : **Siemens Aktiengesellschaft Berlin und München Wittelsbacherplatz 2 D-8000 München 2 (DE)**

(72) Erfinder : **Giebel, Burkhard, Dipl.-Ing. Asenweg 15 D-8000 München 83 (DE)**

EP 0 024 001 B1

Jouve, 18, rue St-Denis, 75001 Paris, France

## Beschreibung

Die Erfindung betrifft eine Schaltungsanordnung gemäß dem Oberbegriff des Anspruchs 1, insbesondere einen Leseverstärker für statische Halbleiter-Festwertspeicher mit in Zeilen und Spalten angeordneten, durch MOS-Speichertransistoren gebildete Speicherzellen, in denen die Speicherzellen in jeder Spalte mit ihren gesteuerten Strecken (Source-Drain-Strecken) an jeweils einer Adreßleitung (Bitleitung) und in jeder Zeile mit ihren Steuerelektroden (Gates) an jeweils einer weiteren Adreßleitung (Wortleitung) liegen.

Durch die DE-AS 26 00 713 ist eine Schaltungsanordnung zum raschen Laden und Entladen eines zum Abtasten des Zustandes von Speicherzellen selektiv mit diesen koppelbaren Abtastknoten in einem statischen Speicher, mit einer Ladeeinrichtung zur Aufladung des Abtastknotens und einem dem Abtastknoten nachgeschalteten Abtastverstärker bekanntgeworden, bei der eine den Stromfluß steuernde, Spannungssprünge am Abtastknoten begrenzende Steuereinrichtung mit dem Abtastknoten verbunden ist und eine Rückkopplungsschleife zwischen dem Ausgang des Abtastverstärkers und der Steuereinrichtung angeordnet ist.

Eine Schaltungsanordnung gemäß dem Oberbegriff des Anspruchs 1 ist aus US-A-4 103 189 bekannt.

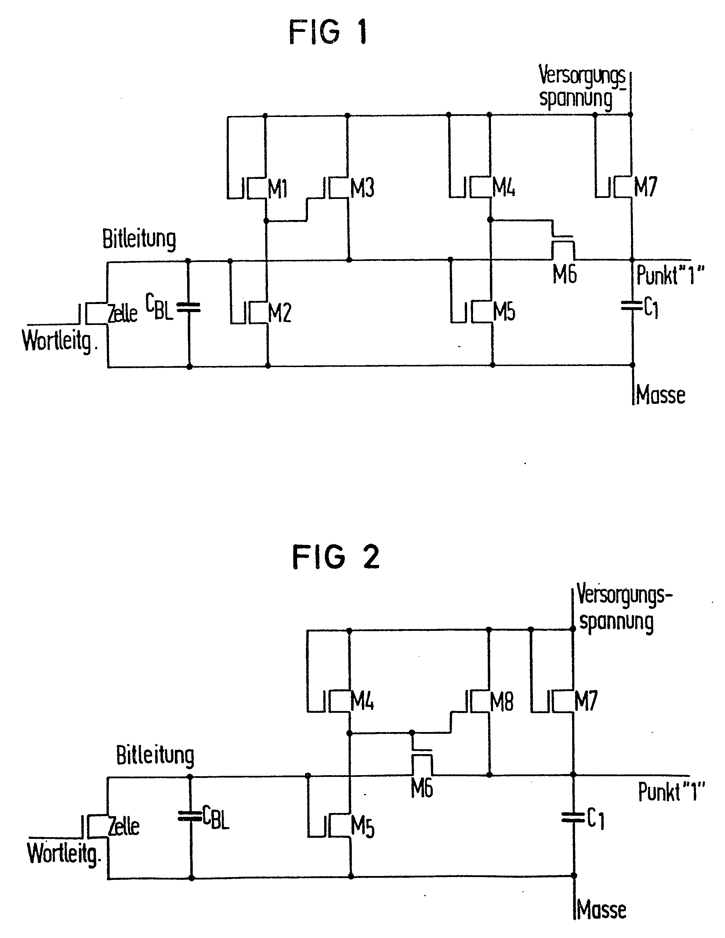

Fig. 1 zeigt das Schaltschema des in einem 16 K-EPROM-Speicherbaustein, Typ 2716 der Fa. Intel, mit den Speicherzellen selektiv verbundenen Leseverstärkers, wobei — betrachtet in Zeichnungsebene — linksseitig eine der Speicherzellen angedeutet ist und mit $C_{BL}$ die parasitäre Bitleitungskapazität und mit $C_1$ die parasitäre Kapazität auf der Ausgangsseite des Leseverstärkers bezeichnet sind.

Dieser Leseverstärker stellt im interessierenden Arbeitsbereich einen Strom-Spannungswandler dar. Der MOS-Transistor M6, der bei dieser bekannten Anordnung wie die übrigen Transistoren vom Anreicherungstyp ist, hebt bei kleinem Eingangs- bzw. Speicherzellenstrom die enge spannungsmäßige Verbindung zwischen Bitleitung BL und Leseverstärkerausgang bzw. Punkt « 1 » auf, wenn die Bitleitungsspannung $U_{BL}$ um höchstens die Schwellspannung $U_T$ des Transistors M6 kleiner ist als die Ausgangsspannung des durch die Bitleitungsspannung $U_{BL}$ gesteuerten Inverters mit den Transistoren M4 und M5. Eine entladene parasitäre Bitleitungskapazität $C_{BL}$ wird durch den Strom des Transistors M7 aufgeladen und zwar solange, bis die effektive Gatespannung am Transistor M6 so klein wird, daß dieser Transistor den Leseverstärkerein- und -ausgang entkoppelt. Der Transistor M7 muß dann nur noch die parasitäre Kapazität $C_1$ am Leseverstärkerausgang laden und nicht mehr die vielfach größere Bitleitungskapazität $C_{BL}$. Hier liegt der Vorteil dieser bekannten Schaltung gegenüber älteren.

Der statische Spannungsendwert des Punktes « 1 » ist dabei durch den gegen Masse fließenden Bitleitungsstrom, d. h. im allgemeinen den Speicherzellenstrom, und durch das W/L-Verhältnis des Transistors M7, d. h. durch das geometrisch bedingte Verhältnis von Kanalbreite zu Kanallänge des Transistors, das ein Kriterium für die Leitfähigkeit des MOS-Transistors ist, bestimmt.

Da der Ladestrom für die parasitären Kapazitäten $C_{BL}$ und $C_1$ immer nur die Differenz $I_{M7}$-$I_{Speicherzelle}$ der durch die Transistoren M7 und die Speicherzelle fließenden Ströme ist, würde die Hochladung einer entladenen Bitleitung bis auf die Bitleitungsspannung, bei der Punkt « 1 » vom Leseverstärkereingang getrennt wird, immer noch sehr langsam erfolgen, wenn nicht der aus den MOS-Transistoren M1 bis M3 bestehende Schaltungsteil in diesem Arbeitsbereich einen vergleichsweise großen Ladestrom unmittelbar aus der Versorgungsspannungsquelle in die Bitleitung einspeisen würde.

Um die tatsächliche Auslesung der Speicherzellen nicht zu behindern, sind die W/L-Verhältnisse der beiden Inverter M1/M2 und M4/M5 so gestaltet, daß der Transistor M3 beim Aufladen der parasitären Bitleitungskapazität $C_{BL}$ auf jeden Fall gesperrt wird, bevor der Transistor M6 beginnt, die Bitleitung bzw. den Leseverstärkereingang vom Leseverstärkerausgang, d. h. vom Punkt « 1 » zu trennen.

Es muß ein Sicherheitsabstand $\Delta U_{BL}$ zwischen den Ansprechspannungen der Schaltungsteile mit den Transistoren M1 bis M3 und M4 bis M7 vorhanden sein, um auch bei unterschiedlichen Schwellspannungen $U_T$ der Transistoren M2 und M5 zu gewährleisten, daß der Schaltungsteil mit den Transistoren M4 bis M7 den Punkt « 1 » bei leitender Speicherzelle noch auf tiefem Potential beläßt bzw. es ermöglicht, daß der Punkt « 1 » über den Transistor M6 auf ein tiefes Potential entladen wird. Dieser Sicherheitsabstand $\Delta U_{BL}$ bedeutet, daß der mit den Transistoren M4 bis M7 bestückte Schaltungsteil mit seinem relativ kleinen Ladestrom die relativ große Bitleitungskapazität $C_{BL}$ um den Betrag dieser Spannungsdifferenz $\Delta U_{BL}$ alleine, d. h. ohne Unterstützung durch den Transistor M3, der sich ja schon im nichtleitenden Zustand befindet, aufladen muß, bevor die Bitleitung vom Punkt « 1 » abgekoppelt wird.

Der vorliegenden Erfindung liegt die Aufgabe zugrunde, eine Schaltungsanordnung zum raschen Bewerten des logischen Zustands eines Abtastknotens und insbesondere einen gegenüber Leseverstärkern der vorstehend beschriebenen Art verbesserten Leseverstärker zu schaffen, der sich bei vereinfachter Schaltung durch eine erhöhte Auslesegeschwindigkeit auszeichnet, wobei die vereinfachte Schaltung unempfindlicher gegen Parameterunterschiede zwischen den Einzeltransistoren ist bzw. bei gleicher Unempfindlichkeit gegenüber dem beschriebenen bekannten Leseverstärker eine erhöhte Auslesegeschwindigkeit gestattet.

Zur Lösung dieser Aufgabe sieht die Erfindung bei einer Schaltungsanordnung der eingangs genannten Art vor, daß die Source des zweiten Transistors mit dem Ausgang der Schaltungsanordnung verbunden ist.

Durch diese Schaltungsanordnung wird, bedingt durch den Wegfall des Schaltungsteiles M1 bis M3, eine Schaltungsvereinfachung erreicht. Dadurch entfällt die beim vorstehend beschriebenen bekannten Leseverstärker bestehende Notwendigkeit, einen zu Lasten der Auslesegeschwindigkeit gehenden Sicherheitsabstand $\Delta U_{BL}$ in den Ansprechspannungen der Schaltungsteile M1 bis M3 und M4 bis M7 vorzusehen. Die Funktion des Schaltungsteiles M1 bis M3 übernimmt der zwischen Versorgungsspannung und Leseverstärkerausgang geschaltete MOS-Transistor, der bei entladener Bitleitung wiederum aus der Versorgungsspannungsquelle einen großen Strom zur Ladung der parasitären Bitleitungskapazität $C_{BL}$ liefert.

Das Schaltschema des Leseverstärkers nach der Erfindung ist in Fig. 2 dargestellt. Die jeweiligen parasitären Bitleitungs- bzw. leseverstärkerausgangsseitigen Kapazitäten und die Schaltungselemente sind, soweit sie mit jenen nach Fig. 1 übereinstimmen, mit den gleichen Bezugszeichen versehen. Der an die Stelle des Schaltungsteiles M1 bis M3 nach Fig. 1 tretende, zwischen Versorgungsspannung und Leseverstärkerausgang geschaltete MOS-Transistor ist mit M8 bezeichnet.

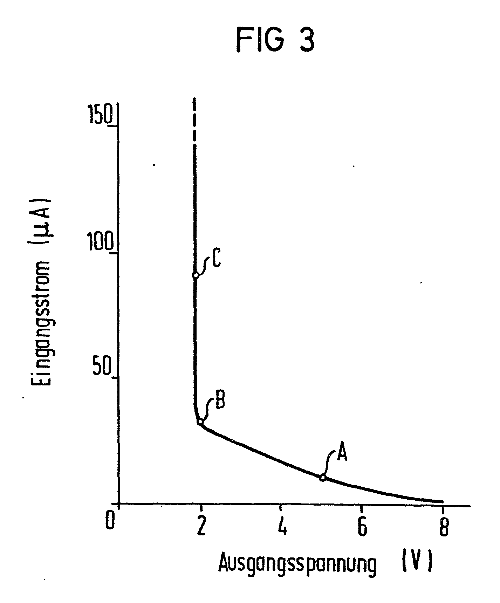

Fig. 3 zeigt die Eingangsstrom-Ausgangsspannungscharakteristik des Leseverstärkers nach Fig. 2, wobei Punkt A den Stromabtastbetrieb und Punkt C den Betriebszustand kennzeichnet, bei dem die Eingangsspannung am Leseverstärker auf einen vorgegebenen Wert festgehalten, d. h. geklemmt wird. Punkt B kennzeichnet den Übergangspunkt, bei dem vom Stromabtastbetrieb auf den Betrieb Klemmen der Eingangsspannung übergegangen wird.

Im Stromabtastbetrieb (Punkt A), d. h. bei niedrigen Eingangsströmen bzw. kleinen Speicherzellenströmen, gleicht statisch der Speicherzellenstrom dem vom MOS-Transistor M7 abgegebenen Strom. In dieser Betriebsstellung ist, verursacht durch den schwachleitenden Zustand des MOS-Transistors M6, der Leseverstärkereingang von seinem Ausgang entkoppelt. Es stellt sich eine dem Leitfähigkeitszustand der Speicherzelle entsprechende Leseverstärkerausgangsspannung ein, die ein Maß für den logischen Zustand der Speicherzelle ist. Bei höherem Eingangsstrom, d. h. bei Erreichen des Übergangspunktes B, fällt die Eingangsspannung am Leseverstärker um einige mV. Dieser geringe Spannungsabfall führt am Ausgang des Inverters M4/M5 zu einem Spannungsanstieg, der ausreicht, um den MOS-Transistor M6 in einen gutleitenden Zustand zu schalten und damit Leseverstärkerein- und -ausgang spannungsmäßig zu koppeln.

Punkt « C », d. h. das Klemmen der Eingangsspannung bzw. das Festhalten der Eingangsspannung auf einem vorgegebenen Wert erfolgt bei einem weiteren Anstieg des Eingangsstromes. Der MOS-Transistor M7 allein ist in dieser Betriebsstellung nicht mehr in der Lage, ausreichend Strom zu liefern, um den Pegel der Eingangsspannung aufrechtzuerhalten. Der weitere geringe Abfall der Eingangsspannung führt zu einem erneuten Anstieg der Ausgangsspannung am Inverter M4/M5, durch den nunmehr auch der MOS-Transistor M8 durchgeschaltet und damit zusätzlich Strom der Speicherzelle zugeführt wird, wodurch die Eingangsspannung auf einen konstanten Wert geklemmt wird.

Zu Beginn der Trennung der Bitleitung vom Punkt « 1 » (Leseverstärkerausgang), d. h. im Übergangspunkt « B », beträgt die Gate-Source-Spannung des MOS-Transistors M8 $U_{GS}$ (M6), verringert um den Drain-Source-Spannungsabfall $U_{DS}$ am Transistor M6. Da die Gate-Source-Spannung des Transistors M8 somit immer um den Betrag $U_{DS}$ (M6) niedriger ist als die Gate-Source-Spannung des Transistors M6, wird der Transistor M8 durch den Beginn der Trennung von Bitleitung und Punkt « 1 » sicher gesperrt und behindert folglich die Auslesung nicht.

Ist die Schwellspannung $U_T$ des Transistors M8 um $\Delta U_T$ geringer als die Schwellspannung $U_T$ des Transistors M6, dann generiert der Leseverstärker selbsttätig den Sicherheitsabstand, der ebenfalls $\Delta U_T$ beträgt, durch zusätzliches Hochladen der gegenüber der parasitären Bitleitungskapazität kleinen Kapazität $C_1$ um diese Spannung $\Delta U_T$, wodurch M8 schließlich gesperrt wird. Dabei muß die Bitleitung nur um eine Spannung $\Delta U_{BL}$ aufgeladen werden, die um den Faktor der Spannungsverstärkung des Inverters M4/M5 geringer ist als $\Delta U_T$ und damit erheblich unter dem Sicherheitsabstand $\Delta U_{BL}$ des beschriebenen bekannten Leseverstärkers liegt. Ist die Schwellspannung $U_T$ des Transistors M8 größer als die Schwellspannung des Transistors M6, so gelten ähnliche Überlegungen.

Der statische Spannungsendwert des Punktes « 1 », d. h. eine dem Leitungszustand der Speicherzelle entsprechende Leseverstärkerausgangsspannung wird somit schneller erreicht als dies beim vorbeschriebenen bekannten Leseverstärker der Fall ist, wobei zusätzlich eine Senkung der Anzahl der Bauelemente von z. B. 7 auf 5 bewirkt wird.

Die Transistoren M4 und M7 des Leseverstärkers nach Fig. 2 können auch als MOS-Transistoren vom Verarmungstyp ausgeführt werden, wobei Gate mit Source verbunden ist.

Die Versorgungsspannungen richten sich im übrigen nach den jeweiligen Gegebenheiten bzw. Erfordernissen.

**Patentansprüche**

1. Schaltungsanordnung mit MOS-Transistoren zum raschen Bewerten des logischen Zustandes eines Abtastknotens (Bitleitung), bei der an dem mit dem Abtastknoten verbundenen Eingang der Schaltungsanordnung ein Inverter (M4/M5) angeordnet ist, dessen Ausgang am Gate eines zwischen Ein- und Ausgang (Punkt « 1 ») der Schaltungsanordnung liegenden ersten Transistors (M6) und am Gate eines zweiten, mit seiner Drain an der Versorgungsspannung liegenden Transistors (M8) liegt, und bei der zwischen der Versorgungsspannung und dem Ausgang ein als Lastwiderstand geschalteter dritter Transistor (M7) liegt, dadurch gekennzeichnet, daß die Source des zweiten Transistors (M8) mit dem Ausgang der Schaltungsanordnung verbunden ist.

2. Schaltungsanordnung nach Anspruch 1, dadurch gekennzeichnet, daß die Schaltungsanordnung als Leseverstärker in einem statischen Halbleiter-Festwertspeicher vorgesehen ist und dem selektiv mit den Speicherzellen verbundenen Abtastknoten nachgeschaltet ist.

3. Schaltungsanordnung nach Anspruch 1 und 2, dadurch gekennzeichnet, daß die MOS-Transistoren (M4 bis M8) vom Anreicherungstyp sind.

4. Schaltungsanordnung nach Anspruch 1 und 2, dadurch gekennzeichnet, daß der als Lastwiderstand geschaltete Transistor (M4) des Inverters (M4/M5) und der zwischen Versorgungsspannung und Ausgang der Schaltungsanordnung liegende und ebenfalls als Lastwiderstand geschaltete Transistor (M7) MOS-Transistoren vom Verarmungstyp sind.

## Claims

1. A circuit arrangement having MOS transistors for the rapid evaluation of the logic state of a sampling node (bit line) wherein there is arranged at that input of the circuit arrangement connected to the sampling node an inverter (M4, M5) whose output is connected to the gate of a first transistor (M6), located between the input and output (point « 1 ») of the circuit arrangement, and it also connected to the gate of a second transistor (M8) whose drain is connected to the supply voltage, and wherein a third transistor (M7) is connected as load resistor between the supply voltage and the output, characterised in that the source of the second transistor (M8) is connected to the output of the circuit arrangement.

2. A circuit arrangement as claimed in Claim 1, characterised in that the circuit arrangement represents a read-out amplifier in a static semiconductor ROM and is connected to the output end of the sampling node which is selectively connected to the storage cells.

3. A circuit arrangement as claimed in Claim 1 and Claim 2, characterised in that the MOS-transistors (M4 to M8) are of the enhancement type.

4. A circuit arrangement as claimed in Claim 1 and Claim 2, characterised in that the transistor (M4) of the inverter (M4, M5), which is connected as a load resistor, together with that transistor (M7) arranged between the supply voltage and the output of the circuit arrangement and likewise connected as a load resistor, are MOS-transistors of the depletion type.

## Revendications

1. Montage à transistors MOS pour la détection rapide de l'état logique d'un nœud de détection (ligne de bits), dans lequel il est prévu, à l'entrée du montage reliée au nœud de détection, un inverseur (M4/M5) dont la sortie est reliée à la grille d'un premier transistor (M6) située entre l'entrée et la sortie (point « 1 ») du montage, et la grille d'un second transistor (M8) dont le drain est porté à la tension d'alimentation, et dans lequel un troisième transistor (M7), monté comme résistance de charge, est situé entre la tension d'alimentation et la sortie, caractérisé par le fait que la source du second transistor (M8) est reliée à la sortie du montage.

2. Montage selon la revendication 1, caractérisé par le fait que le montage est prévu comme amplificateur de lecture dans une mémoire morte à semiconducteurs du type statique, mémoire en aval de laquelle sont prévus des nœuds de détection reliés sélectivement aux cellules de mémorisation.

3. Montage selon la revendication 1 et 2, caractérisé par le fait que les transistors MOS (M4 à M8) sont du type à enrichissement.

4. Montage selon la revendication 1 et 2, caractérisé par le fait que le transistor (M4) de l'inverseur (M4/M5), qui est monté comme résistance de charge, et le transistor (M7) qui est situé entre la tension d'alimentation et la sortie du montage et qui est également monté comme résistance de charge, sont des transistors MOS du type à appauvrissement.

# FIG 1

Versorgungsspannung

M1   M3   M4   M7

Bitleitung

M6

Punkt "1"

Zelle   $C_{BL}$

Wortleitg.   M2   M5   $C_1$

Masse

# FIG 2

Versorgungsspannung

M4   M8   M7

Bitleitung

M6

Punkt "1"

Zelle   $C_{BL}$

Wortleitg.   M5   $C_1$

Masse

# FIG 3